# EUROPÄISCHE PATENTSCHRIFT

(11) **EP 2 248 198 B1**
(45) Veröffentlichungstag und Bekanntmachung des Hinweises auf die Patenterteilung: **20.02.2013**
(21) Anmeldenummer: 08872204.6
(22) Anmeldetag: 25.11.2008
(51) Int. Cl.: H01L 41/113, H02N 2/18, H01L 41/047, B60C 23/04

(54) **BIEGEWANDLER ZUM ERZEUGEN VON ELEKTRISCHER ENERGIE AUS MECHANISCHEN VERFORMUNGEN**
BENDER TRANSDUCER FOR GENERATING ELECTRICAL ENERGY FROM MECHANICAL DEFORMATIONS
TRANSDUCTEUR DE FLEXION UTILISÉ POUR PRODUIRE DE L'ÉNERGIE ÉLECTRIQUE À PARTIR DE DÉFORMATIONS MÉCANIQUES

(30) Priorität: 06.02.2008 DE 102008007774
(43) Veröffentlichungstag der Anmeldung: 10.11.2010
(73) Patentinhaber: Robert Bosch GmbH, 70442 Stuttgart (DE)
(72) Erfinder: HORTIG, Michael, 72800 Eningen U.A. (DE); PANNEK, Thorsten, 70176 Stuttgart (DE); KLETT, Gustav, 72116 Moessingen (DE); KECK, Marian, 71083 Herrenberg (DE)
(86) Internationale Anmeldenummer: PCT/EP2008/066157
(87) Internationale Veröffentlichungsnummer: WO 2009/097925

(56) Entgegenhaltungen:
- WO-A-01/89003
- WO-A-2007/000781
- DE-A1- 10 023 556
- DE-A1- 19 620 826
- DE-A1-102006 012 321
- JP-A- 2004 289 067

## Beschreibung

### Stand der Technik

Piezoelektrische Wandlermechanismen werden insbesondere im Bereich der Sensorik und Aktorik eingesetzt. Zur Wandlung der in deformierten Strukturen entstehenden mechanischen Spannungen wird im Allgemeinen ein piezoelektrisches Element direkt an ein Trägerelement bzw. eine Trägerstruktur angekoppelt, wobei die Trägerstruktur auch ein zweites piezoelektrisches Element sein kann (bekannt als piezoelektrischer Bimorph). Das piezoelektrische Element weist hierbei zwei Elektroden zur Zu- und Ableitung elektrischer Ladungen zu einer Schnittstellenelektronik auf. Die Elektroden sind hierbei im Allgemeinen an den gegenüber liegenden Seiten des meist flachen Piezoelementes ausgebildet

So zeigt z. B. die DE 10 2005 062 872 A1 eine Vorrichtung zur Rollerkennung eines Fahrzeugrades, bei der ein Piezoelement mit an seinen gegenüber liegenden Seiten ausgebildeten Elektroden auf einem Chipträger kontaktiert ist, wobei seine obere Elektrode über einen Drahtbond kontaktiert ist und der Chipträger mit dem Piezoelement und dem Drahtbond in ein Moldcompound eingegossen ist. Bei derartigen Sensoren zur Messung von Beschleunigungen, z. B. Vibrationen, ist somit mit geringem Aufwand eine sichere Kontaktierung möglich.

Weiterhin werden piezoelektrische Materialien zunehmend auch zur Erzeugung von elektrischer Energie aus Umgebungsenergien, insbesondere Vibrationen und Deformationen eingesetzt, was auch als Energy Harvesting bezeichnet wird. Hierbei werden Biegeverformungen des piezoelektrischen Elementes ermöglicht, die zu einer deutlich höheren Energieerzeugung als die z. B. in der DE 10 2005 062 872 A1 zugelassenen mechanischen Verspannungen eines in ein Mold Compound eingegossenen Piezoelementes führen.

Bei Biegewandlern, bei denen sowohl die Trägerstruktur als auch das piezoelektrische Element fest eingespannt ist, kann die elektrische Kontaktierung relativ einfach umgesetzt werden, da das piezoelektrische Element fest mit einem Gehäuse verbunden ist. Für derartige Konstruktionen ist aber im allgemeinen die Verwendung eines hinreichend großflächigen und somit kostspieligen Piezoelementes erforderlich, wobei die Bereiche des Piezoelementes an der Gehäuseanbindung nur relativ geringe mechanische Spannungsänderungen erfahren.

Wenn das piezoelektrische Element nicht fest eingespannt wird, erfolgt die Kontaktierung im allgemeinen über flexible Drahtverbindungen. Diese Drahtverbindungen sind jedoch ebenfalls den auftretenden mechanischen Beanspruchungen ausgesetzt und weisen gegenüber den wiederholten Verformungen nur eine begrenzte Beständigkeit auf.

Aus der Schrift JP 2004 289067 A ist ein piezoelektrischer Bimorph bekannt, das auch als Generator einsetzbar ist, bei dem auf beide Seiten eines elastischen Isolationsträgers jeweils eine Elektrode aufgebracht wird. Jede dieser beiden Elektroden ist mit einem piezoelektrischen Elektrodenaufbau verbunden, so dass die Verbiegung des elastischen Isolationsträgers genutzt werden kann.

Weiterhin ist aus der WO 01/89003 A ein flexibler piezoelektrischer Konverter bekannt, bei dem auf wenigstens einer Seite eines Trägers eine piezoelektrische Einheit aufgebracht wird. Die piezoelektrische Einheit besteht dabei aus einer oder mehreren Lagen eines piezoelektrischen Materials sowie damit verbundene Elektroden.

### Offenbarung der Erfindung

Ein erfindungsgemäßer Biegewandle gemäβ Patentanspruch 1 ermöglicht eine einfache und zuverlässige Kontaktierung des piezoelektrischen Elementes mit dem Trägerelement, insbesondere auch bei Strukturgrößen im Bereich der Feinmechanik. Der Biegewandler eignet sich insbesondere für Anwendungen in der Sensorik und Aktorik zur Energiegewinnung, wobei er als Energiequelle separater oder sogar autarker Systeme wie z. B. von Sensormodulen eingesetzt werden kann.

Unter einem Biegewandler wird erfindungsgemäß eine Vorrichtung verstanden, die bei einer mechanischen Verformung, insbesondere einer nicht gleichmäßigen Verformung, mechanische Energie absorbiert und hieraus durch den piezoelektrischen Effekt elektrische Energie erzeugt. Hierbei können somit insbesondere Biegemomente um ein oder mehrere Achsen aufgenommen werden, gegebenenfalls auch Überlagerungen verschiedener einzelner Biegemomente.

Erfindungsgemäß ist es möglich, piezoelektrische Elemente auf der Struktur der Anschlusselektroden mechanisch zu befestigen. Eine zusätzliche Draht- oder Federkontaktierung kann hierdurch entfallen. Vorteile sind eine einfachere Fertigbarkeit und Montagefähigkeit, wie auch eine erhöhte Zuverlässigkeit insbesondere aufgrund der verbesserten Stabilität

Vorzugsweise sind beide Anschlusselektroden als strukturierte Bereiche einer gemeinsamen leitfähigen Schicht auf der Aufnahmeseite, d.h. im allgemeinen der Oberseite, des Trägers ausgebildet. Die Ausbildung der strukturierten, leitfähigen Schicht ist beispielsweise mittels Lithografie und einem Ätzprozess möglich.

Vorzugsweise ist der Träger flächig ausgebildet und elastisch deformierbar. Das Piezoelement ist vorzugsweise im Bereich maximaler Verformung auf dem Träger angeordnet

Eine vorteilhafte Weiterbildung der Erfindung sieht vor, dass der Träger ganz oder teilweise aus einem leitfähigen Material wie z. B. Metall hergestellt ist, wobei zumindest eine Anschlusselektrode auf einem Isolator, vorzugsweise einer Isolationsschicht angebracht ist.

Dies ermöglicht es insbesondere auch, Metallträger zu verwenden. Metallträger, z. B. aus Stahlblech oder Messingblech, weisen eine hohe Auslenkbarkeit auf, die eine hohe Piezospannung des angebrachten piezoelektrischen Elementes ermöglicht Weiterhin weisen Sie eine gute Elastizität bei geringer Energieabsorption und geringer Materialermüdung auf, so dass der Träger über die Lebenszeit des Biegelementes beständig bleiben kann.

Die Erfindung sieht vor, dass das piezoelektrische Element in mehrere, mindestens zwei Segmente mit unterschiedlicher, vorzugsweise entgegen gesetzter Polarität unterteilt ist. Hierbei kann die genaue Ausbildung an die zu erwartenden mechanischen Verformungen angepasst sein, so dass Energie auch aus komplexen Biegemustern und Biegungen in unterschiedlichen Richtungen erzeugt werden kann.

Erfindungsgemäß wird hierbei erkannt, dass ein kompakter Aufbau erreicht werden kann, indem zwei oder mehr Segmente auf ihrer Oberseite über eine gemeinsame leitfähige Schicht miteinander kontaktiert werden, so dass sie in geeigneter Weise elektrisch miteinander verbunden werden können. Hierbei sind erfindungsgemäß insbesondere Reihenschaltungen zur Erhöhung der Ausgangsspannung vorgesehen. Weiterhin können auch einzelne Segmente oder Reihenschaltungen einzelner Segmente zunächst separat in unterschiedlichen Anschlusskontaktierungen des Trägers kontaktiert und nachfolgend über eine gemeinsame Schaltung, z. B. mit Dioden, als Stromversorgung genutzt werden.

Bei einer nicht beanspruchten Ausbildung des piezoelektrischen Elementes mit lediglich einem Segment mit einheitlicher Polarität kann ein derartiger kompakter Schichtaufbau erreicht werden, indem zum einen die auf der Anschlussseite des piezoelektrischen Elementes ausgebildete erste Elektrode direkt über einen leitfähigen Verbindungsbereich kontaktiert wird und zum anderen die zweite Elektrode nicht nur auf der der Anschlussseite gegenüber liegenden Oberseite des piezoelektrischen Elementes ausgebildet ist, sondern sich zumindest über eine seitlichen Kantenbereich und vorteilhafterweise auch bis zur Anschlussseite erstreckt und dort einen - relativ kleinen - Kontaktierbereich ausbildet, der über einen zweiten leitfähigen Verbindungsmittelbereich mit der zweiten Anschlusselektrode der Trägereinrichtung kontaktiert ist.

Die Kontaktierung zwischen den Anschlusselektroden der Trägereinrichtung und den Elektroden des piezoelektrischen Elementes kann somit vollständig über Bereiche einer leitfähigen Verbindungsmittelschicht erfolgen, vorzugsweise aus Leitkleber oder Lot. Diese Befestigung mit einer flächigen Verbindung weist eine hohe Belastbarkeit auf und gewährleistet eine sichere Kontaktierung. Eine derartig Verbindung ist insbesondere auch gegenüber Schwingungen, Vibrationen und sonstigen Belastungen beständig und weist nicht die diesbezüglichen Nachteile herkömmlicher Drahtbondverbindungen oder anderer Verbindungen mit zusätzlichen Kontaktelementen auf.

Der Biegewandler kann somit vollständig als Schichtstapel aus Trägereinrichtung, piezoelektrischem Element, Leitkleber- oder Lotbereichen und Elektroden bzw. Anschlusselektroden, insbesondere mit im nicht deformierten Zustand planparallelen Schichten ausgebildet werden und ist somit kompakt und mechanisch stabil aufgebaut.

Das piezoelektrische Element kann insbesondere einteilig ausgebildet sein, *erfindungsgemäβ* mit mehreren Segmenten. Es können weiterhin auch mehrere Piezoelemente an einer gemeinsamen Trägereinrichtung vorgesehen sein, z. B. in Reihenschaltung zur Erhöhung der erreichbaren Spannung oder in Parallelschaltung zur Erhöhung der Stromstärke. Die Piezoelemente können hierbei z. B. Biegebeanspruchungen in unterschiedlichen Bereichen der Trägereinrichtung und für unterschiedliche Biegerichtungen aufnehmen. Weiterhin kann auch ein Piezoelement mit mehr als zwei Elektroden vorgesehen sein, z. B. mit vier kreuzweise angeordneten Elektroden, um bei unterschiedlichen Biegebeanspruchungen Energie erzeugen zu können.

Des Weiteren betrifft die Erfindung ein Sensormodul, das einen erfindungsgemäßen Biegewandler als Teil der Stromversorgung aufweist; hierbei kann das erfindungsgemäße Sensormodul insbesondere energetisch autark sein, z. B. mit einem Energiespeicher zur Zwischenspeicherung und/oder Glättung der erzeugten elektrischen Energie. Das Sensormodul kann insbesondere ein Reifensensormodul sein, insbesondere zur Messung eines Reifendrucks, einer Temperatur und/oder von Beschleunigungen, Vibrationen und/oder Verformungen. Ein derartiges erfindungsgemäßes Reifensensormodul kann z. B. direkt in die Lauffläche eines erfindungsgemäßen Reifens eingebunden sein, z. B. in vertikaler Ausrichtung.

Kurze Beschreibung der Zeichnungen
- Fig. 1: zeigt eine nicht beanspruchte erste Ausführungsform eines Biegewandlers mit einsegmentiger Ausbildung des piezoelektrischen Elementes,
- Fig. 2: zeigt eine zweite Ausführungsform eines erfindungsgemäßen Biegewandlers mit mehrsegmentiger Ausbildung des piezoelektrischen Elementes,
- Fig. 3: zeigt eine nicht beanspruchte dritte Ausführungsform eines Biegewandlers mit einsegmentiger Ausbildung des piezoelektrischen Elementes,
- Fig. 4a: zeigt einen Ausschnitt aus Fig. 2 gemäß einer Ausführungsform mit leitfähiger Trägereinrichtung,
- Fig. 4b: zeigt einen Ausschnitt aus Fig. 2 gemäß einer Ausführungsform mit nicht leitfähiger Trägereinrichtung.
- Fig. 5: zeigt ein erfindungsgemäßes Schaltmodul in perspektivischer, geschnittener Ansicht.

### Ausführungsformen der Erfindung

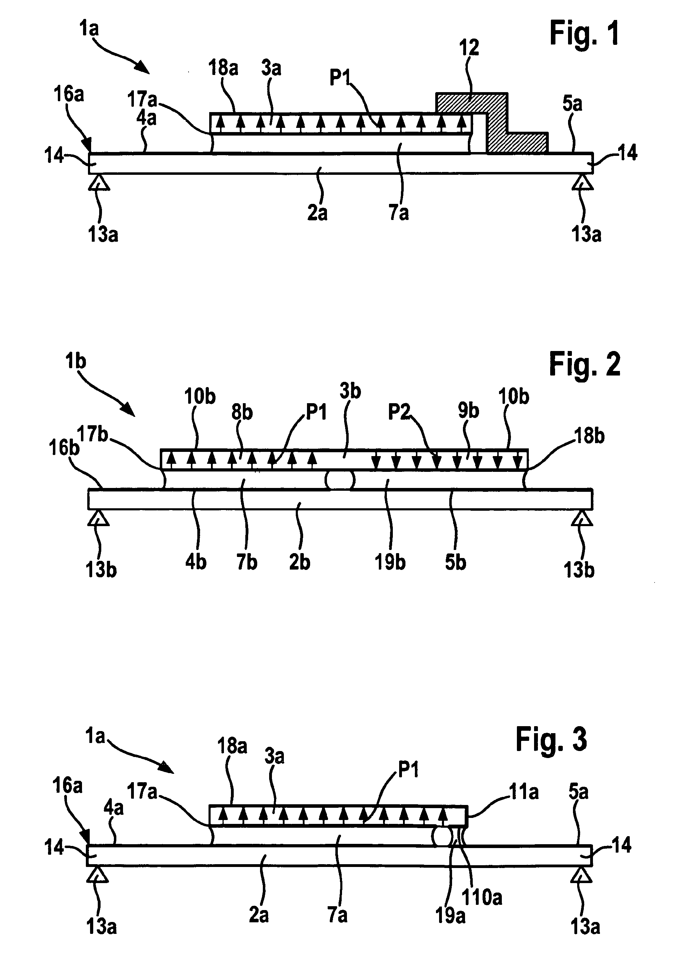

Ein in Fig. 1 gezeigter nicht beanspruchter Biegewandler 1a umfasst einen deformierbaren Träger 2a und ein piezoelektrisches Element 3a. Der Träger 2a weist eine flächige und planparallele Form auf und ist elastisch deformierbar; hierbei ist er mit seinen zwei gegenüberliegenden Seitenbereichen 14 auf Stützelementen 13a gelagert oder eingespannt, so dass eine Verformung zwischen diesen Stützelementen, insbesondere eine Biegeverformung, ermöglicht wird. Auf der Oberseite 16a des Trägers 2a sind eine erste Anschlusselektrode 4a und zweite Anschlusselektrode 5a als Teil einer strukturierten, leitfähigen Schicht, insbesondere Metallschicht, mittels eines Lithografie - und Ätzprozesses aufgebracht und erstrecken sich in seitlicher, lateraler Richtung nach außen.

Auch das piezoelektrische Element 3a ist flächig ausgebildet; es ist insbesondere aus einem Keramikmaterial gefertigt und weist bei dieser Ausführungsform eine einheitliche Polarisationsrichtung P1 auf. Es weist an seiner als Anschlussseite dienenden Unterseite eine erste, untere Elektrode 17a und auf seiner Oberseite eine zweite, obere Elektrode 18a auf, wobei beide Elektroden 17a und 18a z. B. als Metallschichten aufgebracht sind. Das piezoelektrische Element 3a ist derart auf dem Träger 2a im Bereich dessen maximaler Verformung, d.h. insbesondere in dessen lateral mittlerem Bereich, angeordnet, dass seine Polarisationsrichtung P1 senkrecht zum Träger 2a orientiert ist.

Das piezoelektrische Element 3a ist mit seiner unteren Elektrode 17a mittels einer stoffschlüssigen, leitfähigen Schicht 7a, insbesondere einer leitfähigen Kleberschicht 7a oder auch Lotschicht 7a, mechanisch fest mit der ersten Anschlusselektrode 4a verbunden und kontaktiert.

Die obere Elektrode 18a ist über ein Kontaktblech 12, insbesondere ein doppelt abgewinkeltes Kontaktblech, mit der zweiten Anschlusselektrode 5a kontaktiert.

Somit wird ein mechanisch stabiles Stapelsystem aus dem Träger 2a, Kleber 7a und piezoelektrischen Element 3a gebildet. Bei einer Biegebeanspruchung des Trägers 2a zwischen den Stützelementen 13a wird das piezoelektrische Element 3a entsprechend verformt, wobei die von ihm erzeugte Piezospannung über die Anschlusselektroden 4a und 5a und somit über die Oberseite des Trägers 2a abgegriffen werden kann.

Bei der Ausführungsform der Fig. 2 sind wiederum auf der Oberseite 16b eines elastisch deformierbaren, nicht leitfähigen, flächigen und planparallelen Trägers 2b eine erste Anschlusselektrode 4b und zweite Anschlusselektrode 5b als Bereiche einer strukturierten, leitfähigen Schicht, insbesondere Metallschicht, ausbildet. Der Träger 2b entspricht somit im wesentlichen dem Träger 2a aus Fig. 1 und unterscheidet sich von diesem durch die genaue Strukturierung der Anschlusselektroden 4b und 5b.

Das piezoelektrische Element 2b unterteilt sich in ein erstes Segment 8b und ein zweites Segment 9b mit gegenläufig orientierten Polarisationen **P1** und P2. Auf der Oberseite des piezoelektrischen Elementes 2b ist eine durchgängige leitfähige Schicht 10b, insbesondere Metallschicht 10b, aufgetragen, die somit die Oberseiten beider Segmente 8b, 9b bedeckt und mit einander kontaktiert. Auf der Unterseite des piezoelektrischen Elementes 2b ist eine strukturierte leitfähige Schicht, insbesondere Metallschicht aufgetragen und derartig strukturiert, dass sie eine erste Elektrode 17b und eine zweite Elektrode 18b ausbildet. Hierbei ist eine leitfähige Kleberschicht oder Lotschicht derartig auf die Oberseite 16b des Trägers 2b aufgetragen, dass sie zwischen der ersten Elektrode 17b und der ersten Anschlusselektrode 4a einen ersten leitfähigen, stoffschlüssigen Kleberbereich 7b und zwischen der zweiten Elektrode 5b und der zweiten Anschlusselektrode 4a einen zweiten leitfähigen, stoffschlüssigen Kleberbereich 19b ausbildet.

Somit sind die beiden Segmente 8b und 9b des piezoelektrischen Elementes 3b über die gemeinsame Metallschicht 10b kontaktiert und in Reihe zwischen die Anschlusselektroden 4b und 5b geschaltet.

Der nicht beanspruchte Biegewandler 1a der Ausführungsform der Fig. 3 weist ein einsegmentiges piezoelektrisches Element 3a entsprechend Fig. 1 auf, wobei die zweite Elektrode 18a nicht nur auf der Oberseite des piezoelektrischen Elementes 3a ausgebildet ist, sondern sich auch mit einem Kantenbereich 11a über die Seitenfläche erstreckt und bis zur Unterseite bzw. Anschlussseite des piezoelektrischen Elementes verläuft, wo die zweite Elektrode einen lateral zu der ersten Elektrode 17a beabstandeten Kontaktierbereich 110a ausbildet, der mit der zweiten Anschlusselektrode 5a kontaktiert ist. Somit wird auch in Fig. 3 ein kompakter Schichtaufbau erreicht, bei dem sich beide Anschlusselektroden 4a und 5a bis unter das piezoelektrische Element 3a erstrecken und die Kontaktierung über zwei leitfähige Verbindungsmittelbereiche 7a, 19a erfolgt.

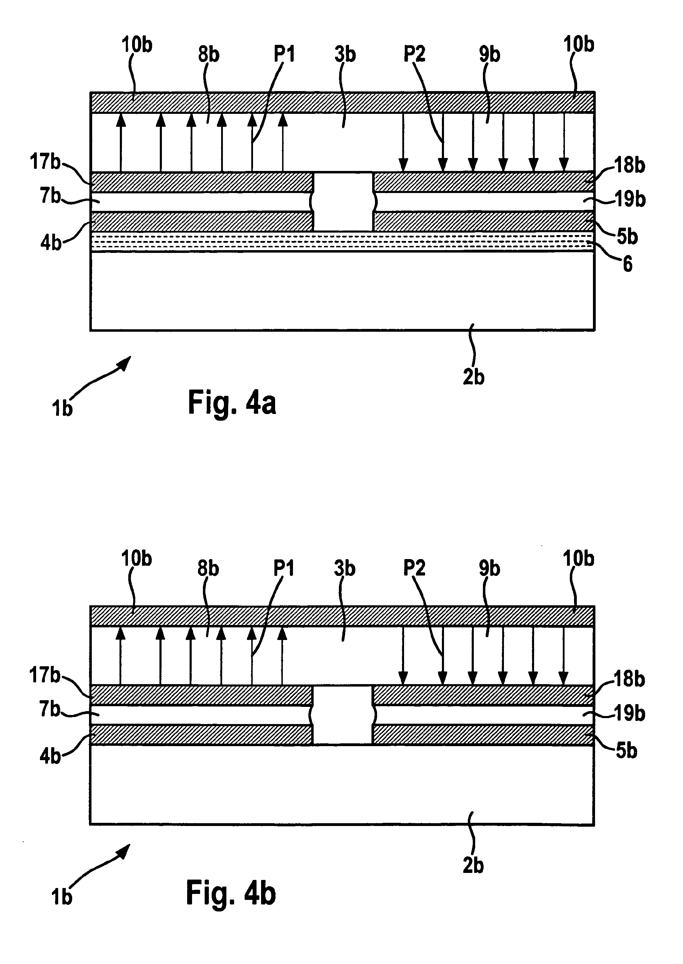

Bei sämtlichen Ausführungsformen der Fig. 1, 2 und 3 kann der Träger 2a oder 2b wahlweise aus einem leitfähigen Materia oder nicht leitfähigem Material ausgebildet sein. Fig. 4a und Fig. 4b zeigen diese beiden Ausbildungen beispielhaft für die zweisegmentige Ausführungsform der Fig. 2, wobei sie entsprechend auch auf Fig. 1 und 3 zu übertragen sind.

In Fig. 4a ist der Träger 2b aus einem elektrisch leitfähigen Material ausgebildet, insbesondere als Metall-Träger, z. B. aus Stahlblech oder Messingblech ausgebildet, das eine hohe Auslenkung bei guter Elastizität und geringer Materialermüdung aufweist. Zwischen dem Träger 2b und den Anschlusselektroden 4b und 5b ist eine Isolierschicht 6 aufgetragen, die einen elektrischen Kontakt zwischen dem Träger 2b und den Anschlusselektroden 4b und 5b verhindert. Alternativ hierzu kann allerdings der Metallträger 2b auch direkt als eine der Anschlusselektroden verwendet werden, indem z. B. die Isolationsschicht 6 unterhalb der Elektrode 17b ausgespart ist und der Verbindungsmittelbereich 7b direkt auf den Träger 2b aufgetragen ist, der somit die erste Anschlusselektrode bildet, wobei die Schicht 4b somit entfallen kann.

Bei der Ausführungsform der Fig. 4b besteht der Träger 2a aus einem nicht leitfähigen Material, z. B. Kunststoff oder Keramik, so dass hier gegenüber der Fig. 4a die Isolationsschicht 6 entfällt und die Anschlusskontakte 4b und 5b direkt auf der Oberseite bzw. Aufnahmeseite des Trägers 2b ausgebildet sind.

Die Erfindung ist nicht auf die oben beschriebenen Elektrodenstrukturen beschränkt Je nach Abhängigkeit von der Applikation, Wandlerstruktur (beispielsweise bimorphe Wandler) und dem Verlauf der Biegelinie oder Biegelinien können andere Elektrodenstrukturen vorteilhafter sein. Hierbei können an dem piezoelektrischen Element auch z. B. mehr als zwei Elektroden ausgebildet sein, z. B. in einer kreuzförmigen Anordnung zur Ausgabe einer Piezospannung bei unterschiedlichen oder S-förmigen Biegeverläufen, wobei dann jeweils zwei oder mehr Elektroden über eine Diodenschaltung verbunden sind.

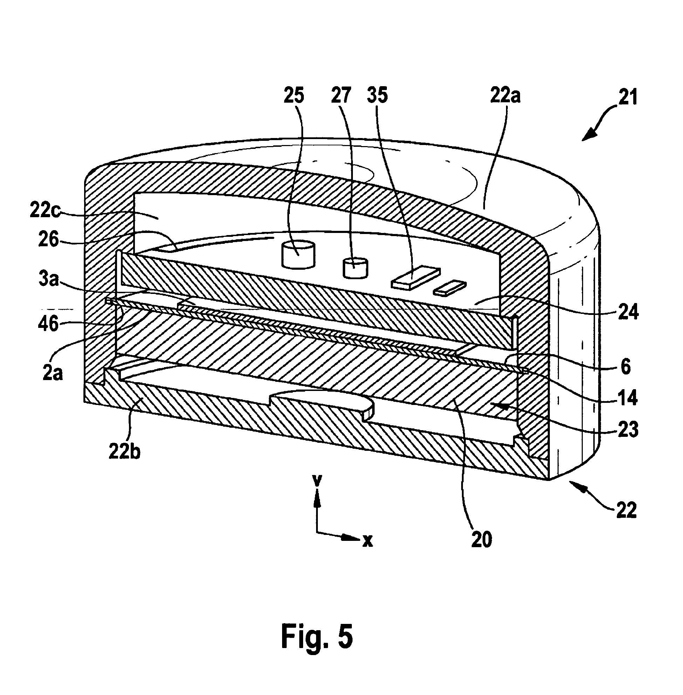

Die beschriebenen Biegewandler 1a, 1b eignen sich insbesondere als Stromversorgung, z. B. für ein Schaltungsmodul, wobei weitere Energiequellen, beispielsweise eine Batterie, überflüssig sein können. Fig. 5 zeigt als eine Ausführungsform eines derartigen Schaltungsmoduls ein Sensormodul 21 im Querschnitt, das ein Gehäuse 22 mit einem topfförmigen Gehäuseoberteil 22 a und einem deckelförmigen bzw. scheibenförmigen Gehäuseunterteil 22 b aufweist, die einen Gehäuseinnenraum 22 c umgeben. In dem Gehäuseinnenraum 22 c sind ein piezoelektrischer Generator (PEG) 23 und ein Schaltungsträger 24 mit hier nur angedeuteter Modulelektronik 25, 27, 35 aus SMD-Bauelementen aufgenommen. Die Modulelektronik 25, 27, 35 kann je nach Einsatz des Schaltungsmoduls 21 unterschiedliche Bauelemente aufweisen. Hierbei ist eine Stromversorgungsschaltung 25 zur Aufnahme der Piezo-Spannung und zur Bereitstellung der Versorgungsspannung, vorteilhafterweise auch ein Energiespeicher zur Zwischenspeicherung der Energie bei zeitweise diskontinuierlichem Betrieb vorgesehen. Bei Verwendung als Reifendruckkontrollsystem (TPMS) sind weiterhin ein Drucksensor 27 und als Bauelemente 35 eine Steuereinheit, z.B. ein ASIC, und für den Betrieb der Antenne relevante HF-Bauteile, z.B. ein Oszillator und ggf. ein HF-ASIC, auf dem z.B. als Leiterplatte ausgebildeten Schaltungsträger 24 montiert. Die in Fig. 2 angedeutete Antenne 26 kann z.B. als Schleifenantenne am äußeren Rand des Schaltungsträgers 24 umlaufen; grundsätzlich kann die Antenne 26 jedoch z.B. auch im oder am Gehäuse 22, z.B. an der Innenwand des Gehäuses 22 verlaufen oder auch in das Gehäuse 22 eingespritzt sein. Bei Verwendung als Reifendruckkontrollsystem weist das Gehäuse 22 ein Loch als Druckzuführung von außen auf. Das Sensormodul 21 kann insbesondere mit seiner Symmetrieachse v in radialer Richtung des Fahrzeugreifens aufgenommen sein, so dass sich der Träger 2a oder 2b und das Piezoelement 3a oder 3b in lateraler Richtung x erstrecken.

Der piezoelektrische Generator 23 weist ein in dem Gehäuseinnenraum 22 c bewegbar bzw. verstellbar aufgenommenes Masseelement 20, den Metall-Träger 2a oder 2b als metallisches Federelement und das piezoelektrisches Element 3a oder 3b auf. Der Träger 2a oder 2b ist im Wesentlichen als Blattfeder ausgebildet und weist entsprechend Fig. 4a auf seiner Oberseite die Isolierschicht 6 auf, auf der die hier nicht gezeigten Anschlusskontakte ausgebildet sind.

Der metallische Träger 2a oder 2b ist in eine Gehäusenut 46 in der Innenwand 22c des Gehäuseoberteils 22 a eingelegt. Seine Enden 14 können eingespannt oder nicht eingespannt sein, wodurch unterschiedliche Frequenzen und Biegeformen erreicht werden können. Bei einer eingespannten Aufnahme sind die Enden 14 an ihrer Ober- und Unterseite fest in der Gehäusenut 46 aufgenommen; bei einer nicht eingespannten Aufnahme liegen die Enden entsprechend Fig. 1 bis 3 mit ihrer Unterseite auf den Stützelementen 13a oder 13b auf und können nach oben durchwölben.

Das Sensormodul 21 kann insbesondere als Reifensensormodul für die Messung eines Reifendrucks, der Temperatur und/oder von Beschleunigungen, Vibrationen und Schwingungen genutzt werden. Es können somit über den Biegewandler Vibrationen und Deformationen in Energie umgewandelt und zur Stromversorgung verwendet werden.

## Patentansprüche

1. Biegewandler (1b) zum Erzeugen von elektrischer Energie aus mechanischen Verformungen, der mindestens aufweist:
eine deformierbare Trägereinrichtung (2b), an der eine erste Anschlusselektrode (4b) und eine zweite Anschlusselektrode (5b) ausgebildet sind,
ein auf der Trägereinrichtung (2b) befestigtes piezoelektrisches Element (3b) mit mindestens einer ersten Elektrode (17b) und einer zweiten Elektrode (18b),
wobei
- die erste Anschlusselektrode (4b) mit der ersten Elektrode (17b) des piezoelektrischen Elementes (3b) und die zweite Anschlusselektrode (5b) mit der zweiten Elektrode (18b) des piezoelektrischen Elementes (3b) kontaktiert ist, und
- die erste Anschlusselektrode (4b) und die zweite Anschlusselektrode (5b) als Bereiche mindestens einer strukturierten, leitfähigen Schicht auf der Trägereinrichtung (2b) aufgebracht sind, **dadurch gekennzeichnet, dass**
- die erste Elektrode (17b) und/oder die zweite Elektrode (18b) stoffschlüssig mittels eines leitfähigen Verbindungsmittels (7b, 19b), z. B. Leitkleber oder Lot, mechanisch auf der jeweils zugeordneten Anschlusselektrode (4b,5b) befestigt und kontaktiert ist/sind, und
- beide Anschlusselektroden (4b; 5b) bereichsweise unterhalb des piezoelektrischen Elementes (3b) ausgebildet sind und sich lateral nach außen erstrecken, und
- die erste Elektrode (17b) stoffschlüssig mittels eines ersten leitfähigen Verbindungsmittelbereichs (7b) mechanisch auf der ersten Anschlusselektrode (4b) befestigt und kontaktiert ist, und
- die zweite Elektrode (18b) stoffschlüssig mittels eines zweiten leitfähigen Verbindungsmittelbereichs (19b) mechanisch auf der zweiten Anschlusselektrode (5b) befestigt und kontaktiert ist, und
- das piezoelektrische Element (3b) mindestens ein erstes Segment (8b) und ein zweites Segment (9b) mit unterschiedlich orientierter, vorzugsweise gegenläufiger, Polarisation (P1, P2) aufweist,
- wobei an dem ersten Segment (8b) die erste Elektrode (17b) und an dem zweiten Segment (9b) die zweite Elektrode (18b) ausgebildet ist, und
das erste Segment (8b) und das zweite Segment (9b) elektrisch in Reihe geschaltet sind.

2. Biegewandler nach Anspruch 1, **dadurch gekennzeichnet, dass** die erste Anschlusselektrode (4b) und die zweite Anschlusselektrode (5b) als Bereiche einer gemeinsamen strukturierten, leitfähigen Schicht auf der Trägereinrichtung (2b) aufgebracht sind.

3. Biegewandler nach Anspruch 1 oder 2, **dadurch gekennzeichnet, dass** die Trägereinrichtung (2b) ein leitfähiges Material aufweist, und
zwischen der Trägereinrichtung (2b) und der ersten und zweiten Anschlusselektrode (4b; 5b) eine Isolierung (6) ausgebildet ist.

4. Biegewandler nach Anspruch 3, **dadurch gekennzeichnet, dass** die Trägereinrichtung (2b) vollständig aus Metall gefertigt ist und auf ihrer Aufnahmeseite die Isolierung, z. B. eine Isolationsschicht (6), aufgetragen ist.

5. Biegewandler nach Anspruch 3 oder 4, **dadurch gekennzeichnet, dass** eine Anschlusselektrode (4b; 5b) auf der Isolierung (6) ausgebildet ist und die Trägereinrichtung (2b) als die andere Anschlusselektrode (4b; 5b) wirkt und mit einer der beiden Elektroden (17b; 18b) kontaktiert ist.

6. Biegewandler nach Anspruch 1, **dadurch gekennzeichnet, dass** die Trägereinrichtung (2b), das Verbindungsmittel (7b, 19b), die Elektroden (17b; 18b) und das piezoelektrische Element (3b) gemeinsam als Schichtsystem mehrerer übereinander liegender Schichten ausgebildet sind.

7. Schaltungsmodul (21), das mindestens aufweist:
ein Gehäuse (22),
einen in dem Gehäuse aufgenommenen piezoelektrischen Generator (23), der ein innerhalb des Gehäuses (22) bewegbares Masseelement (20) und einen Biegewandler (1b) nach einem der Ansprüche 1 bis 6 aufweist,
wobei das Masseelement (10) und der Biegewandler (1b) ein schwingfähiges System bilden und das piezoelektrische Element (3b) bei der Schwingung des schwingfähigen Systems elastisch verformbar ist, und
eine Stromversorgungsschaltung (25) zur Aufnahme einer von dem piezoelektrischen Element (3b) bei seiner mechanischen Verformung ausgegebenen Piezo-Spannung und zur Stromversorgung des Schaltungsmoduls (21).

8. Schaltungsmodul nach Anspruch 7, **dadurch gekennzeichnet, dass** es ein energetisch autarkes Sensormodul, insbesondere Reifensensormodul für die Messung eines Reifeninnendrucks und/oder einer Temperatur und/oder von Beschleunigungen ist.

## Claims

1. Bending transducer (1b) for generating electrical energy from mechanical deformations, which bending transducer has at least:
a deformable support device (2b) on which a first connection electrode (4b) and a second connection electrode (5b) are formed,
a piezoelectric element (3b), which is mounted on the support device (2b) and has at least a first electrode (17b) and a second electrode (18b),
with
- the first electrode (17b) of the piezoelectric element (3b) making contact with the first connection electrode (4b), and the second electrode (18b) of the piezoelectric element (3b) making contact with the second connection electrode (5b), and
- the first connection electrode (4b) and the second connection electrode (5b) being applied to the support device (2b) as regions of at least one patterned, conductive layer,
**characterized in that**
- the first electrode (17b) and/or the second electrode (18b) are mechanically mounted on the respectively associated connection electrode (4b, 5b) in a cohesive manner by means of a conductive connecting means (7b, 19b), for example conductive adhesive or solder, and contact is made with the said first and/or second electrode, and
- the two connection electrodes (4b; 5b) are formed in regions beneath the piezoelectric element (3b) and extend laterally outwards, and
- the first electrode (17b) is mechanically mounted on the first connection electrode (4b) in a cohesive manner by means of a first conductive connecting means region (7b), and contact is made with the said first electrode, and
- the second electrode (18b) is mechanically mounted on the second connection electrode (5b) in a cohesive manner by means of a second conductive connecting means region (19b), and contact is made with the said second electrode, and
- the piezoelectric element (3b) has at least a first segment (8b) and a second segment (9b) with differently oriented, preferably opposite, polarization (P1, P2),
- with the first electrode (17b) being formed on the first segment (8b) and the second electrode (18b) being formed on the second segment (9b), and
the first segment (8b) and the second segment (9b) being electrically connected in series.

2. Bending transducer according to Claim 1, **characterized in that** the first connection electrode (4b) and the second connection electrode (5b) are applied to the support device (2b) as regions of a common patterned, conductive layer.

3. Bending transducer according to Claim 1 or 2, **characterized in that** the support device (2b) has a conductive material, and an insulation (6) is formed between the support device (2b) and the first and second connection electrodes (4b; 5b).

4. Bending transducer according to Claim 3, **characterized in that** the support device (2b) is produced entirely from metal and the insulation, for example an insulation layer (6), is applied on the receiving side of the said support device.

5. Bending transducer according to Claim 3 or 4, **characterized in that** a connection electrode (4b; 5b) is formed on the insulation (6), and the support device (2b) acts as the other connection electrode (4b; 5b) and one of the two electrodes (17b; 18b) makes contact with the said support device.

6. Bending transducer according to Claim 1, **characterized in that** the support device (2b), the connecting means (7b, 19b), the electrodes (17b; 18b) and the piezoelectric element (3b) are jointly formed as a layer system comprising a plurality of layers which are situated one above the other.

7. Circuit module (21) which has at least:
a housing (22),
a piezoelectric generator (23) which is accommodated in the housing and has a mass element (20), which can move within the housing (22), and a bending transducer (1b) according to one of Claims 1 to 6,
with the mass element (10) and the bending transducer (1b) forming an oscillating system, and the piezoelectric element (3b) being elastically deformable when the oscillating system oscillates, and
a power supply circuit (25) for receiving a piezo voltage, which is output by the piezoelectric element (3b) when it is mechanically deformed, and for supplying power to the circuit module (21).

8. Circuit module according to Claim 7, **characterized in that** it is a sensor module, in particular a tyre sensor module for measuring an internal pressure of a tyre and/or a temperature and/or accelerations, which is independent in respect of energy.

## Revendications

1. Convertisseur flexible (1b) pour générer de l'énergie électrique à partir de déformations mécaniques, lequel présente au moins :
un dispositif porteur (2b) déformable sur lequel sont formées une première électrode de raccordement (4b) et une deuxième électrode de raccordement (5b),
un élément piézoélectrique (3b) fixé sur le dispositif porteur (2b), comprenant au moins une première électrode (17b) et une deuxième électrode (18b),
- la première électrode de raccordement (4b) étant mise en contact avec la première électrode (17b) de l'élément piézoélectrique (3b) et la deuxième électrode de raccordement (5b) étant mise en contact avec la deuxième électrode (18b) de l'élément piézoélectrique (3b), et
- la première électrode de raccordement (4b) et la deuxième électrode de raccordement (5b) étant appliquées sur le dispositif porteur (2b) sous la forme de zones d'au moins une couche structurée conductrice, **caractérisé en ce que**
- la première électrode (17b) et/ou la deuxième électrode (18b) est/sont fixée(s) et mise(s) en contact mécaniquement sur l'électrode de raccordement (4b, 5b) respectivement associée par cohésion de matières à l'aide d'un moyen de liaison (7b, 19b) conducteur, par exemple de la colle conductrice ou de la soudure, et
- les deux électrodes de raccordement (4b ; 5b) sont formées dans certaines zones au-dessous de l'élément piézoélectrique (3b) et s'étendent latéralement vers l'extérieur, et
- la première électrode (17b) est fixée et mise en contact mécaniquement sur la première électrode de raccordement (4b) par cohésion de matières à l'aide d'une première zone de moyen de liaison (7b) conductrice, et
- la deuxième électrode (18b) est fixée et mise en contact mécaniquement sur la deuxième électrode de raccordement (5b) par cohésion de matières à l'aide d'une deuxième zone de moyen de liaison (19b) conductrice, et
- l'élément piézoélectrique (3b) présente au moins un premier segment (8b) et un deuxième segment (9b) dont les polarisations (P1, P2) sont orientées différemment, de préférence en sens opposé,
- la première électrode (17b) étant formée sur le premier segment (8b) et la deuxième électrode (18b) sur le deuxième segment (9b), et
- le premier segment (8b) et le deuxième segment (9b) étant branchés électriquement en série.

2. Convertisseur flexible selon la revendication 1, **caractérisé en ce que** la première électrode de raccordement (4b) et la deuxième électrode de raccordement (5b) sont appliquées sous la forme de zones d'une couche structurée conductrice commune sur le dispositif porteur (2b).

3. Convertisseur flexible selon la revendication 1 ou 2, **caractérisé en ce que** le dispositif porteur (2b) présente un matériau conducteur et une isolation (6) est formée entre le dispositif porteur (2b) et la première et la deuxième électrodes de raccordement (4b ; 5b).

4. Convertisseur flexible selon la revendication 3, **caractérisé en ce que** le dispositif porteur (2b) est entièrement fabriqué en métal et l'isolation, par exemple une couche isolante (6), est appliquée sur son côté d'accueil.

5. Convertisseur flexible selon la revendication 3 ou 4, **caractérisé en ce qu'**une électrode de raccordement (4b ; 5b) est formée sur l'isolation (6) et le dispositif porteur (2b) remplit le rôle de l'autre électrode de raccordement (4b ; 5b) et est mis en contact avec l'une des deux électrodes (17b ; 18b).

6. Convertisseur flexible selon la revendication 1, **caractérisé en ce que** le dispositif porteur (2b), le moyen de liaison (7b, 19b), les électrodes (17b ; 18b) et l'élément piézoélectrique (3b) sont formés en commun sous la forme d'un système de couches composé de plusieurs couches disposées les unes au-dessus des autres.

7. Module de commutation (21) qui présente au moins :
un boîtier (22),
un générateur piézoélectrique (23) logé dans le boîtier, lequel présente un élément de masse (20) mobile à l'intérieur du boîtier (22) et un convertisseur flexible (1b) selon l'une des revendications 1 à 6,
l'élément de masse (10) et le convertisseur flexible (1b) formant un système oscillant et l'élément piézoélectrique (3b) pouvant être déformé par flexibilité en cas d'oscillation du système oscillant, et
un circuit d'alimentation électrique (25) pour recevoir une tension piézoélectrique délivrée par l'élément piézoélectrique (3b) lors de sa déformation mécanique et pour alimenter électriquement le module de commutation (21).

8. Module de commutation selon la revendication 7, **caractérisé en ce qu'**il est un module de détection autonome sur le plan énergétique, notamment un module de détection pour pneu pour la mesure d'une pression interne de pneu et/ou d'une température et/ou d'accélérations.
